# EUROPÄISCHE PATENTSCHRIFT

(11) **EP 0 521 473 B1**
(45) Veröffentlichungstag und Bekanntmachung des Hinweises auf die Patenterteilung: **11.09.1996**
(21) Anmeldenummer: 92111099.5
(22) Anmeldetag: 01.07.1992
(51) Int. Cl.: C30B 25/02

(54) **Mehrschichtige, kristallines Siliziumkarbid enthaltende Zusammensetzung**
Multi-layered composition containing crystalline silicon carbide
Composition multi-couche contenant le carbure de silicium cristallin

(30) Priorität: 02.07.1991 DE 4121798
(43) Veröffentlichungstag der Anmeldung: 07.01.1993
(73) Patentinhaber: Daimler-Benz Aktiengesellschaft, D-70546 Stuttgart (DE)
(72) Erfinder: Niemann, Ekkehard, W-6457 Maintal 4 (DE); Grueninger, Hans Wolfgang, Dr., W-6239 Kriftel (DE); Leidich, Dieter, W-6000 Frankfurt/Main 90 (DE)
(74) Vertreter: Vogl, Leo, Dipl.-Ing.

(56) Entgegenhaltungen:
- EP-A- 0 269 439
- WO-A-88/04333
- DE-A- 3 446 956
- GB-A- 1 115 237
- PATENT ABSTRACTS OF JAPAN vol. 113, no. 12 (E-548)12. Oktober 1987
- PATENT ABSTRACTS OF JAPAN vol. 113, no. 12 (E-548)12. Oktober 1987
- DEER, F.R.S., HOWIE, R.A., ZUSSMAN, J. "An Introduction to the Rock-Forming Minerals", 1966, LONGMAN, London, GB, p. 405

## Beschreibung

Die Erfindung betrifft eine mehrschichtige, kristallines Siliziumkarbid enthaltende Zusammensetzung mit einem von Siliziumkarbid verschiedenen, diesem bezüglich seines Kristallgitters angepassten Einkristall-Substrat, wobei das Siliziumkarbid auf dem Einkristall-Substrat aufgewachsen ist und ein Verfahren zur Herstellung einer solchen Zusammensetzung.

Eine derartige Zusammensetzung ist aus der GB-A-1 115 237 bekannt, die der US-A-3,463,666 entspricht. Dort wird eine einkristalline β-SiC-Schicht offenbart, die auf einer einkristallinen Saphirschicht aufgewachsen ist. Die Abscheidung der einkristallinen β-SiC-Schicht erfolgt durch Gasphasenreaktion bei Temperaturen zwischen 1650 und 2000 °C. Aus den Patent Abstracts of Japan, Vol. 113, No. 12 (E-548), JP-A-62 105 416, 12. Oktober 1987, ist eine Zusammensetzung bekannt, bei der eine Schicht aus kristallinem α-Siliziumkarbid auf monokristallinem Spinell mit der keramischen Formel MgO · Al₂O₃ aufgewachsen ist. Diese Schicht aus Spinell entsteht durch Festkörperreaktion einer MgO-Schicht mit einer Saphirunterlage.

Aus den Patent Abstracts of Japan: JP-A-62 105 468 (Sharp Corp.), 15. Mai 1987, ist es bekannt, einen Block aus Saphir-Substrat vollständig außen mit einer dünnen, monokristallinen Schicht aus Zirkonoxid, welche durch eine Beimengung von Magnesiumoxid oder Yttriumoxid stabilisiert ist, zu bedecken. Diese dünne Schicht soll die Anpassung des Kristallgitters gegenüber Saphir oder Silizium an die Kristallstruktur von auf der Schicht befindlichem Siliziumkarbid verbessern und einen abträglichen Einfluß der Saphirunterlage auf elektronische Halbleiterbausteine verhindern. Der Zirkonfilm dient der Gitteranpassung für die auf ihm befindliche Schicht aus Siliziumkarbid. Der unter dem Zirkonfilm befindliche Saphirblock dient als Träger.

Eine ähnliche Zusammensetzung ist aus der internationalen Anmeldung mit der internationalen Veröffentlichungsnummer WO 88/04333 bekannt. Dort ist beschrieben, wie kristallines Siliziumkarbid mit einer bevorzugten Ausrichtung im kristallinen Aufbau durch plasmaunterstützte chemische Dampfabscheidung (PECVD) auf einem geeigneten Substrat gezüchtet wird. Als mögliche Trägersubstrate werden Titankarbid (TiC) und monokristallines Silizium genannt. Nähere Angaben zum kristallinen Aufbau von geeignetem Trägersubstrat sind der internationalen Anmeldung nicht zu entnehmen. Wenn in die Siliziumkarbid-Schicht, die auf dem Einkristall-Substrat aufgewachsen ist, laterale Bauelemente eingearbeitet werden sollen, ist Titankarbid (TiC) nicht als Material für das Einkristall-Substrat geeignet; Titankarbid weist nämlich einen spezifischen Widerstand von ca. 52 · 10⁻⁶ Ohm·m und wirkt daher als ein elektrischer Leiter und nicht als ein Isolator. Ausserdem ist Titankarbid in grossflächiger, monokristalliner Ausführung nur sehr schwer erhältlich und recht teuer, was einen wirtschaftlichen Einsatz unmöglich macht.

Aus der DE-OS 34 46 956 ist ein Verfahren zur Herstellung eines Einkristall-Substrats aus Siliziumkarbid bekannt, bei dem ein Einkristallfilm aus Alpha-Siliziumkarbid auf einem einkristallinen Trägersubstrat aus Beta-Siliziumkarbid gezüchtet wird. Nachteilig bei der Verwendung von Siliziumkarbid als Züchtungssubstrat ist der extrem hohe Preis geeigneter Wafer aus monokristalinem Siliziumkarbid.

In der EP-A-0 269 439 ist ein Verfahren zum Aufwachsen von Siliziumkarbid auf einkristallinem Silizium beschrieben. Dabei kann allerdings nicht die Ähnlichkeit des Kristallgitters von Grundsubstrat und aufwachsender Schicht ausgenutzt werden. Das Gitter eines Silizium-Einkristalls weist nämlich eine von Beta-Siliziumkarbid verschiedene Gitterkonstante auf; die Gitterkonstante von Silizium beträgt 5,43 · 10⁻¹⁰ m.

Der Erfindung liegt die Aufgabe zugrunde, eine möglichst kostengünstige kristalline Zusammensetzung zu schaffen, bei der eine möglichst grossflächige Schicht aus kristallinem Siliziumkarbid, in die laterale Bauelemente integrierbar sind, auf einem Einkristall-Substrat mit einem geeigneten Kristallgitter aufgetragen ist.

Diese Aufgabe wird erfindungsgemäß durch eine mehrschichtige Zusammensetzung nach Anspruch 1 gelöst.

Vorteilhaft ist bei einer derartigen Zusammensetzung zum einen, dass als Substratmaterial nicht monokristallines Siliziumkarbid nötig ist, welches in grossflächiger Ausführung sehr teuer ist, und zum andern, dass das Substrat isolierend wirkt; durch diese Isolationswirkung des Substrats eignet sich die auf dem Substrat aufgewachsene, einkristalline Schicht zur Einarbeitung von lateralen - d. h. an der Oberfläche der kristallinen Zusammensetzung befindlichen - elektronischen Bauelementen. Das Substrat übernimmt zusätzlich eine Stützfunktion für die einkristalline Schicht aus Siliziumkarbid.

Die Dotierung der Bauelemente zur Erzeugung von n-leitenden und p-leitenden Zonen wird während der Herstellung vorgenommen. Wegen des hohen Bandabstandes sind Halbleiterbauelemente aus Siliziumkarbid - im Vergleich zu elektronischen Bauelementen aus anderen Halbleitermaterialien - auch bei höheren Temperaturen einsatzfähig. Deshalb sind sie auch für die Leistungselektronik geeignet.
Siliziumkarbid-feldeffekttransistoren werden bei Temperaturen bis zu 500°C betrieben. SiC-Bauelemente kommen ohne Kühlkörper aus und sind deshalb in verhältnismässig kleiner und leichter Ausführung herstellbar. Sie zeichnen sich zusätzlich durch ihre hohe Beständigkeit gegen überlastungen und hochenergetische Strahlung aus. SiC-Dioden haben einen um mehrere Grössenordnungen niedrigeren Leckstrom als entsprechende Si-Dioden.
Elektronische Bauelemente mit den erwähnten Eigenschaften werden in der Automobil- oder Flugzeugindustrie, bei Ölbohrungen, im Kernkraftwerk, im Weltraum oder einfach zur Steuerung von Hochtemperatur-Kreisen benötigt. Es ist eine Weiterentwicklung von SiC-Bauelementen in der Weise zu erwarten, dass sie sich auch unter extremen chemischen und physikalischen Bedingungen betreiben lassen.

Bei dem Einkristallsubstrat nach Anspruch 2, nämlich MgAl₂O₄, ist eine günstige Anpassung zwischen dem Einkristallsubstrat und dem monokristallinen Siliziumkarbid gegeben, denn der Wert der Gitterkonstanten von MgAl₂O₄ beträgt ca. 8,08 · 10⁻¹⁰ m und ist damit ungefähr doppelt so gross wie der von Beta-Siliziumkarbid. Eine Anlagerung von Siliziumkarbid in einkristalliner Form ist im Falle des doppelt so grossen Gitterabstandes beim (Träger-)Substrat besonders gut möglich. Ungefähr jedes zweite Atom des Siliziumkarbids lagert sich nämlich an ein Atom des MgAl₂O₄-Gitters an.
Vorzugsweise ist gemäss Anspruch 5 das Siliziumkarbid Beta-Siliziumkarbid, welches eine kubische Gitterstruktur hat und eine Gitterkonstante von 4,3 · 10⁻¹⁰ m bis 4,4 · 10⁻¹⁰ m aufweist. Das erfindungsgemässe Einkristall-Substrat ist daher besonders gut an das Beta-Siliziumkarbid angepasst.

Weitere vorteilhafte Ausbildungen sind den übrigen Unteransprüchen zu entnehmen. Ein Verfahren zur Herstellung der erfindungsgemässen Zusammensetzung ist in Anspruch 7 beschrieben.

Die Erfindung wird im folgenden an Hand zweier Ausführungsbeispiele, aus denen sich weitere Merkmale, Einzelheiten und Vorteile ergeben, näher beschrieben.

Das eine Beispiel betrifft die Verwendung von Magnesiumoxid (MgO) als ein Einkristallsubstrat, das andere Beispiel die Verwendung von Zirkonoxid (ZrO₂); als Substrat kann aber auch Spinell (MgAl₂O₄) verwendet werden.
Eine Scheibe aus einkristallinem Magnesiumoxid bzw. aus einkristallinem Zirkonoxid wird zunächst angeschliffen, und zwar in einem Winkel von 1° bis 8° gegenüber den zu der flachen Oberfläche parallelen Netzebenen des jeweiligen Kristallgitters. Die Netzebenen sind diejenigen Ebenen in einem Kristallgitter (eines Einkristalls), die durch die regelmässige Anordnung der Atome oder Ionen in dem Kristallgitter gebildet werden und auf denen in gleichen Abständen Atome oder Ionen des Kristalls angeordnet sind. Diese Bezeichnung leitet sich von der anschaulichen Vorstellung her, dass man die Atome oder Ionen mit den regelmässig angeordneten Knoten eines Netzes vergleichen kann. Zu jeder Netzebene gibt es in einem Einkristall mehrere parallele Netzebenen.
Durch das Anschleifen wird die fehlerfreie Anlagerung von Bausteinen an das jeweilige Einkristall-Substrat begünstigt; das Anschleifen führt nämlich - bei Zugrundelegung eines Modells im atomaren Bereich - zu einem stufigen Verlauf der Kristalloberfläche. Wenn die Stufen annähernd gleich hoch sind, lagern sich die Bausteine auf allen Stufen in ungefähr der gleichen Geschwindigkeit an; dieser Anlagerungsmechanismus begünstigt ein gleichmässiges, fehlerfreies Kristallwachstum. Die seitliche Anlagerung von Bausteinen an ein Kristall wird wegen des Energiegewinns und dem damit verbundenen Übergang in einen stabileren Zustand gegenüber dem Aufbau einer neuen Ebene bevorzugt.
Die angeschliffene Oberfläche der Scheibe wird mit Ethanol (C₂H₅OH) oder anderen Alkoholen gereinigt.

Falls eine Scheibe aus Magnesiumoxid als Einkristall-Substrat verwendet wird, muss die Scheibe nach dem Reinigungsvorgang ca. zwei Stunden lang bei ca. 1200 °C getempert werden. Diese Massnahme soll bewirken, dass die beim Reinigungsvorgang entstandenen Feuchtigkeitsanlagerungen wieder beseitigt werden.
Bei Verwendung einer Scheibe aus Zirkonoxid kann dieser Verfahrensschritt ausgelassen werden, d. h. es ist nach dem Reinigen kein Aufheizvorgang erforderlich.

Auf die angeschliffene und gereinigte Oberfläche der Scheibe wird eine Schicht aus Beta-Siliziumkarbid durch Schichtabscheidung aus der Gasphase aufgetragen. Dazu wird ein plasmaunterstütztes CVD-Verfahren (PECVD: plasma enhanced chemical vapour deposition) eingesetzt.
Dass Spinell, Magnesiumoxid und Zirkonoxid besonders gut als (Träger-)Substrat zum Züchten von einkristallinem Beta-Siliziumkarbid geeignet sind, macht ein Vergleich ihrer Gitterkonstanten mit der Gitterkonstanten des Beta-Siliziumkarbids deutlich.

Beim plasmaunterstützten CVD-Verfahren wird zunächst die Scheibe auf eine Temperatur von ca. 620° C gebracht. Für die Schichtabscheidung wird ein Gasfluss von ca. 40 sccm Silan (SiH₄), ca. 375 sccm Argon (Ar) und ca. 770 sccm Ethen (C₂H₄) über die erhitzte Scheibe geleitet. Damit die Gase dissoziieren und sich dadurch auf der Scheibe Siliziumkarbid abscheidet, werden die Gase einer rf-Leistung (rf: radio frequency) von ca. 10 W bei einer Frequenz von ca. 13,56 MHz und einem Druck von ca. 0,8 mbar ausgesetzt.

Anschliessend wird die gesamte kristalline Zusammensetzung in einem Ofen (Temperrohr) bei einer Temperatur von ca. 1200° C zwei Stunden lang in Argon rekristallisiert (das Argon wird in einer Menge von ca. 1 l/min durch den Ofen geleitet); bei dieser Temperatur richten sich die Zonen mit kristallinem Aufbau einheitlich aus, und es entsteht auf dem Einkristall-Substrat nahezu fehlerfreies, monokristallines Siliziumkarbid. Die Aufheizzeit des Ofens von Zimmertemperatur auf 1200 °C beträgt etwa 3 Stunden.

Besonders günstig für eine industrielle Produktion ist eine Gasphasenepitaxie des Siliziumkarbids. Dazu wird bei einer Temperatur von ca. 1400 °C das Siliziumkarbid unmittelbar aus der Gasphase auf der Pufferschicht abgeschieden (vgl. Applied Physics Letters, Ausg. 42, Nr. 5, 1. März 1983, Seite 461). Bei der Abscheidung bildet sich direkt das monokristalline Siliziumkarbid, und es wird das oben beschriebene Rekristallisieren als zusätzlicher Verfahrensschritt eingespart.

In die Oberfläche der einkristallinen Siliziumkarbidschicht, die auf dem Träger aufgetragen ist, lassen sich elektronische Bauelemente integrieren. Damit die Bauelemente betrieben werden können, muss der Träger isolierend sein. Spinell (rho ca. 1 . 10¹⁶ Ohm·cm), Magnesiumoxid (spezifischer Widerstand rho > 1 · 10¹⁴ Ohm·cm) und Zirkonoxid (rho > 10¹¹ Ohm·cm) sind geeignete Träger mit Isolationswirkung.

## Patentansprüche

1. Mehrschichtige, monokristallines Siliziumkarbid enthaltende Zusammensetzung mit einem von Siliziumkarbid verschiedenen, diesem bezüglich seines Kristallgitters angepaßten elektrisch isolierenden Einkristall-Substrat, wobei das Siliziumkarbid auf dem Einkristall-Substrat aufgewachsen ist,
**dadurch gekennzeichnet,**
daß das Einkristall-Substrat eine Gitterkonstante im Bereich von 4,0 · 10⁻¹⁰m bis 5,2 · 10⁻¹⁰m oder einem ganzzahligen Vielfachen davon aufweist und daß das Einkristall-Substrat gegenüber den Netzebenen seines Kristallgitters in einem Winkel von 1° bis 8° angeschliffen ist.

2. Mehrschichtige Zusammensetzung nach Anspruch 1, dadurch gekennzeichnet, daß das Einkristall-Substrat Spinell (Mg Al₂ O₄) ist.

3. Mehrschichtige Zusammensetzung nach Anspruch 1, dadurch gekennzeichnet, daß das Einkristall-Substrat Magnesiumoxid (MgO) ist.

4. Mehrschichtige Zusammensetzung nach Anspruch 1, dadurch gekennzeichnet, daß das Einkristall-Substrat Zirkonoxid (ZrO₂) ist.

5. Mehrschichtige, kristallines Siliziumkarbid enthaltende Zusammensetzung nach einem der vorangehenden Ansprüche, dadurch gekennzeichnet, daß das monokristalline Siliziumkarbid Beta-Siliziumkarbid ist.

6. Verfahren zur Herstellung einer mehrschichtigen Zusammensetzung nach einem der vorangehenden Ansprüche,
dadurch gekennzeichnet,
daß zunächst eine Scheibe aus dem Einkristall-Substrat auf einer seiner Oberflächen in einem Winkel von 1° bis 8° gegenüber den Netzebenen seines Kristallgitters angeschliffen wird, daß anschließend die Oberfläche mit Ethanol gereinigt wird, daß danach bei einer Temperatur von ca. 620 °C, bei einem Druck von ca. 0,8 mbar, bei einer rf-Leistung von ca. 10 W und bei einer Frequenz von ca. 13,56 MHz ca. 40 sccm Silan (SiH4), ca. 375 sccm Argon (Ar) und ca. 770 sccm Ethen (C₂H₄) zur Abscheidung von Siliziumkarbid über die Scheibe geleitet werden und daß schließlich bei ca. 1200 °C ca. zwei Stunden lang die Scheibe in Argon rekristallisiert wird, wobei im Falle einer Scheibe aus Magnesiumoxid als Einkristall-Substrat nach dem Reinigen mit Ethanol und vor der Abscheidung von Siliziumkarbid diese Scheibe bei ca. 1200 °C zwei Stunden lang erhitzt wird.

## Claims

1. Multi-layer composition containing monocrystalline silicon carbide and with an electrically insulating single crystal substrate which differs from the silicon carbide and which is matched to this with respect to its crystal lattice, wherein the silicon carbide is grown on the single crystal substrate, characterised thereby that the single crystal substrate has lattice constant in the range of 4.0 · 10⁻¹⁰m to 5.2 · 10⁻¹⁰m or an integral multiple thereof and that the single crystal substrate is ground at an angle of 1° to 8° relative to the crystal-lattice plane of its crystal lattice.

2. Multi-layer composition according to claim 1, characterised thereby that the single crystal substrate is spinel (Mg Al₂ O₄).

3. Multi-layer composition according to claim 1, characterised thereby that the single crystal substrate is magnesium oxide (MgO).

4. Multi-layer composition according to claim 1, characterised thereby that the single crystal substrate is zircon oxide (ZrO₂).

5. Multi-layer comoosition, which contains crystalline silicon carbide, according to one of the preceding claims, characterised thereby that the monocrystalline silicon carbide is beta silicon carbide.

6. Method of producing a multi-layer composition according to one of the preceding claims, characterised thereby that initially a slice consisting of the single crystal substrate is ground on one of its surfaces at an angle of 1° to 8° relative to the crystal-lattice plane of its crystal lattice, that subsequently the surface is cleaned with ethanol, that thereafter about 40 sccm of silane (SiH₄), about 375sccm of argon (Ar) and about 770 sccm of ethene (C₂H₄) is conducted over the slice at a temperature of about 620°C, at a pressure of about 0.8 mbar, at a rf power of about 10 W and at a frequency of about 13.56 MHz for the precipitation of silicon carbide and that finally the slice is recrystallised in argon for about two hours at about 1200°C, wherein in the case of a slice of magnesium oxide as single crystal substrate this slice is heated for two hours at about 1200°C after the cleaning with ethanol and before the precipitation of silicon carbide.

## Revendications

1. Composition multicouche contenant du carbure de silicium monocristallin, comprenant un substrat monocristallin, électriquement isolant, différent du carbure de silicium et adapté à ce dernier en ce qui concerne son réseau cristallin, le carbure de silicium étant engendré par épitaxie sur un substrat monocristallin,
caractérisée en ce que,
le substrat monocristallin présente une constante de réseau dans la plage de 4,0 . 10-¹⁰ m à 5,2 . 10⁻¹⁰ m ou un multiple entier et en ce que le substrat monocristallin est poli suivant un angle de 1° à 8° par rapport aux plans de réseau d'un réseau cristallin.

2. Composition multicouche selon la revendication 1, caractérisée en ce que le substrat monocristallin est du spinelle (Mg Al₂ O₄).

3. Composition multicouche selon la revendication 1, caractérisée en ce que le substrat monocristallin est de l'oxyde de magnésium (MgO).

4. Composition multicouche selon la revendication 1, caractérisée en ce que le substrat monocristallin est de l'oxyde de zirconium (ZrO₂).

5. Composition multicouche contenant du carbure de silicium cristallin selon l'une des revendications précédentes, caractérisée en ce que le substrat monocristallin est du carbure de silicium bêta.

6. Procédé de fabrication d'une composition multicouche selon l'une des revendications précédentes,
caractérisé en ce que
tout d'abord une galette du substrat monocristallin est polie sur l'une de ses surfaces suivant un angle de 1° à 8° par rapport aux plans de réseaux de son réseau cristallin, en ce qu'ensuite la surface est nettoyée à l'éthanol, en ce qu'après, à une température d'environ 620°C, une pression d'environ 0,8 mbar et une puissance fr d'environ 10 W et une fréquence d'environ 13,56 MHz, environ 40 sccm de Silane (SiH₄), environ 375 sccm d'argon (Ar) et environ 770 sccm d'éthylène (C₂H₄) sont dirigées sur la galette pour la précipitation du carbure de silicium et que, pour finir, la galette est recristallisée pendant deux heures à 1200°C dans l'argon, dans le cas d'une galette en oxyde de magnésium en tant que substrat monocristallin après le nettoyage à l'éthanol, et avant la précipitation du carbure de silicium, cette galette est chauffée pendant deux heures à environ 1200°C.
